# EUROPEAN PATENT APPLICATION

(11) **EP 4 239 670 A1**
(43) Date of publication of application: **06.09.2023**
(21) Application number: 22191243.9
(22) Date of filing: 19.08.2022
(51) Int. Cl.: H01L 23/373, H01L 23/433, H01L 23/473, H01L 23/495

(54) **POWER MODULE FOR VEHICLE AND METHOD OF MANUFACTURING THE SAME**

(30) Priority: 04.03.2022 KR 20220028377
(71) Applicant: HYUNDAI MOTOR COMPANY, Seoul 06797 (KR); Kia Corporation, Seocho-gu Seoul 06797 (KR)
(72) Inventor: KONG, Nam Sik, 18280 Hwaseong-si, Gyeonggi-do (KR); PARK, Jun Hee, 18280 Hwaseong-si, Gyeonggi-do (KR); KIM, Tae Hwa, 18280 Hwaseong-si, Gyeonggi-do (KR)
(74) Representative: Isarpatent

(57) **Abstract**

A power module for a vehicle includes: a circuit board including a circuit pattern; a semiconductor chip connected to a first side of the circuit board; a lead frame disposed on the circuit board as being spaced apart from the semiconductor chip, and electrically connected to the semiconductor chip; and a cooling channel coupled to a second side of the circuit board and inserted in and jointed to a coolant flow channel of a cooler.

## Description

### TECHNICAL FIELD

The disclosure relates to a power module for a vehicle, which is mounted to an inverter for operating a driving motor provided in an electric vehicle, and a method of manufacturing the same.

### BACKGROUND

Power modules are used to supply high voltage and current to operate motors for hybrid vehicles, electric vehicles, and the like.

Among the power modules, a double-sided cooling power module includes boards respectively installed at the upper and lower sides of a semiconductor chip and heat dissipation plates respectively, provided on the outer sides of the boards. The double-sided cooling power module has better cooling performance than a single-sided cooling power module including a heat dissipation plate on one side, and thus has been increasingly used.

In the double-sided cooling power module used for the electric vehicle or the like, a power chip made of silicon carbide (SiC), gallium nitride (GaN), or the like semiconductor is mounted between two boards, and generates heat of high temperatures due to high voltage and vibration during driving. To solve the heat and vibration problems, the double-sided cooling power module needs to satisfy both high strength and high heat dissipation characteristics.

Matters described as the related art are provided merely for promoting understanding for the background of the disclosure, and should not be taken as the prior art already known to a person having ordinary knowledge in the art.

### SUMMARY

An aspect of the disclosure is to directly cool a circuit board by bonding a cooling channel coupled to a cooler to a lower side of the circuit board, and coupling an insulator for insulating the circuit board to the cooler.

According to an embodiment of the disclosure, a power module for the vehicle includes: a first circuit board including a circuit pattern; a first semiconductor chip connected to a first side of the first circuit board; a lead frame disposed on the first circuit board as being spaced apart from the first semiconductor chip, and electrically connected to the first semiconductor chip; and a first cooling channel coupled to a second side of the first circuit board and inserted in and jointed to a first coolant flow channel of a first cooler.

The first cooling channel may include a cooling fin extended toward the first coolant flow channel of the first cooler.

The cooling fin may have an end portion spaced apart from a lower surface of the first coolant flow channel.

The first cooling channel may include a plurality of cooling fins disposed in a preset pattern and extended toward the first coolant flow channel of the first cooler.

The power module may further include an insulator surrounding outer sides of the first circuit board and the first semiconductor chip and a lateral side of the first cooling channel.

The first cooling channel may be extended from the insulator toward the first cooler and inserted in the first coolant flow channel of the first cooler.

The insulator may be welded to an outer side of the first cooler.

The power module may further include a copper clip to connect with the first semiconductor chip or the lead frame as coupled to the first side of the first circuit board.

The first semiconductor chip or the lead frame may be coupled to the first circuit board by soldering or sintering.

The power module may further include a spacer, a second circuit board, a second semiconductor chip, and a second cooling channel. The first semiconductor chip, the first circuit board, and the first cooling channel may be sequentially arranged on one side of the spacer in a direction away from the spacer, and the second semiconductor chip, the second circuit board, and the second cooling channel may be sequentially arranged on another side of the spacer opposing the one side in a direction away from the spacer.

The first and second circuit boards may be symmetrically provided up and down forming a pair, the first and second cooling channels may be symmetrically provided up and down forming a pair, the first and second semiconductor chip may be respectively connected to the first and second circuit boards forming a pair.

According to an embodiment of the disclosure, a method of manufacturing a power module for a vehicle includes: coupling a semiconductor chip, a cooling channel, and a lead frame to a circuit board; molding an insulator of an epoxy resin on an outer side of the circuit board; curing the molded insulator; and welding the insulator and the cooling channel together after inserting the cooling channel in a cooler.

The method may further include trimming the lead frame for signal connection with a gate board after the curing.

### BRIEF DESCRIPTION OF THE DRAWINGS

FIG. 1 is a lateral cross-sectional view of a power module for a vehicle according to an embodiment of the disclosure.
FIG. 2 is a lateral cross-sectional view of a power module for a vehicle according to another embodiment of the disclosure.
FIG. 3 is a perspective view of a power module for a vehicle according to an embodiment of the disclosure.
FIG. 4 is a cross-sectional view taken along lines A-A in FIG. 3.
FIG. 5 is a view showing thermal analyses of a conventional power module and the power modules according to the embodiments of the disclosure.
FIG. 6 is a flowchart showing a method of manufacturing a power module for a vehicle according to the disclosure.
FIG. 7 is a view illustrating the method of manufacturing a power module for a vehicle according to the disclosure.

### DETAILED DESCRIPTION

Regarding embodiments of the disclosure disclosed in this specification or application, the specific structural or functional description is merely illustrative for the purpose of describing the embodiments of the disclosure, and embodiments of the disclosure may be implemented in various forms but not be construed as being limited to the embodiments set forth in this specification or application.

Because the embodiments of the disclosure may be variously modified and have various forms, specific exemplary embodiments will be illustrated in the drawings and described in detail in this specification or application. However, it should be understood that embodiments of the disclosure are intended not to be limited to the specific embodiments but to cover all modifications, equivalents or alternatives without departing from the spirit and technical scope of the disclosure.

Terms such as "first" and/or "second" are used herein merely to describe a variety of elements, but the elements are not limited by these terms. Such terms are used only for the purpose of distinguishing one element from another element. For example, without departing from the conceptual scope of the disclosure, a first element may be referred to as a second, and vice versa.

When a certain element is referred to as being "connected to" or "coupled to" another element, it will be understood that they may be directly connected to or coupled to each other but or intervening elements may be present therebetween. On the other hand, when a certain element is referred to as being "directly connected to" or "directly coupled to" another element, it will be understood that no intervening elements are present therebetween. Other expressions describing relationships between elements, such as "between," "immediately between," "adjacent to," "directly adjacent to," or etc. may also be construed in the same manner.

Terms used in this specification are merely used for explaining specific embodiments, but not intended to limit the disclosure. Unless the context clearly dictates otherwise, singular forms include plural forms as well. It is to be understood that terms "include," "have," etc. as used herein specify the presence of stated features, integers, steps, operations, elements, components, or combination thereof, but do not preclude the presence or addition of one or more other features, integers, steps, operations, elements, components or combination thereof.

Unless defined otherwise, all terms used herein including technical or scientific terms have the same meanings as those generally understood by a person having ordinary knowledge in the art to which the disclosure pertains. The terms such as those defined in generally used dictionaries are construed to have meanings matching that in the context of related technology and, unless clearly defined otherwise, are not construed to be ideally or excessively formal.

Below, the disclosure will be described in detail by describing embodiments with reference to the accompanying drawings. Like reference numerals in the drawings refer to like numerals.

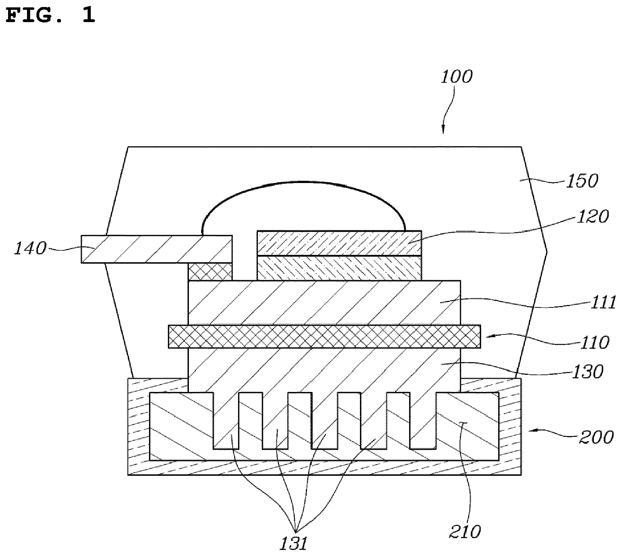

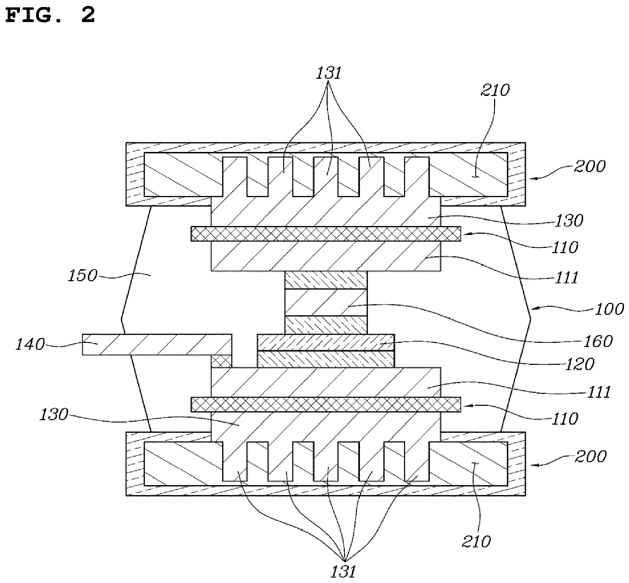

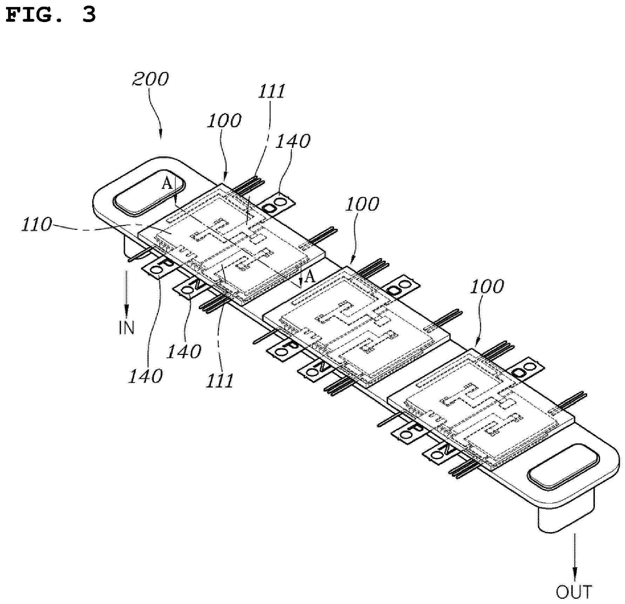

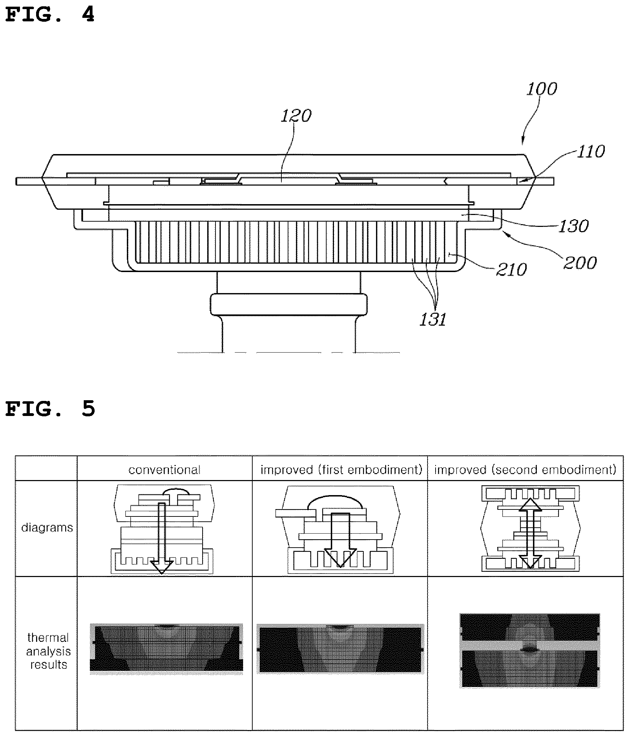

FIG. 1 is a lateral cross-sectional view of a power module 100 for a vehicle according to an embodiment of the disclosure, FIG. 2 is a lateral cross-sectional view of a power module 100 for a vehicle according to another embodiment of the disclosure, FIG. 3 is a perspective view of a power module 100 for a vehicle according to an embodiment of the disclosure, FIG. 4 is a cross-sectional view taken along line A-A in FIG. 3, and FIG. 5 is a view showing thermal analyses of a conventional power module 100 and the power modules 100 according to the embodiments of the disclosure.

Embodiments of the power module 100 for the vehicle according to the disclosure will be described with reference to FIGS. 1 to 5.

The power module 100 for the vehicle according to the disclosure includes a circuit board 110 formed with a circuit pattern 111; a semiconductor chip 120 connected to a first side of the circuit board 110; a lead frame 140 disposed on the circuit board 110 as being spaced apart from the semiconductor chip 120 and electrically connected to the semiconductor chip 120; and a cooling channel 130 coupled to a second side of the circuit board 110 and inserted in and jointed to a coolant flow channel 210 of a cooler 200.

The circuit board 110 includes the circuit pattern 111 formed on the first side thereof and made of metal that enables current to flow. The first side of the circuit board 110 provided with the circuit pattern 111 may connect with the semiconductor chip 120.

Further, the circuit board 110 may connect with the lead frame 140 where current flows in and out to receive an electrical signal from the outside or transmit an electric signal.

The circuit board 110 includes the cooling channel 130 formed on the second side thereof and made of metal. The cooling channel 130 is connected to the cooler 200 provided with the coolant flow channel where a coolant flows. The cooling channel 130 is injected in and joined to the coolant flow channel 210, thereby directly cooling the circuit board 110.

Conventionally, it has been designed to bond the cooling channel 130 to the bottom of the circuit board 110, bond a thermal interface material (TIM) to the lower portion of the cooling channel 130, and connect the cooling channel 130 to the cooler 200. However, such conventional design has problems in that cooling efficiency is low and manufacturing is inefficient due to many processes.

On the other hand, according to the disclosure, the cooling channel 130 is coupled to the lower portion of the circuit board 110 and the cooler 200 is directly coupled to the cooling channel 130, so that heat generated in the semiconductor chip 120 when current flows in the circuit board 110 can directly dissipate, thereby having a significant effect on increasing the cooling efficiency.

The cooling channel 130 may be made of copper (Cu) in consideration of heat dissipation performance. The thickness of the cooling channel 130 may be greater than or equal to 1 mm. The circuit board 110 may have a thermal conductivity of 80 W/mK or higher.

The cooling channel 130 may include a cooling fin 131 extended toward the coolant flow channel 210 of the cooler 200.

As shown in FIGS. 1 to 4, the cooling channel 130 may be joined to the cooler 200 as inserted in the coolant flow channel 210 of the cooler 200, and include the cooling fin 131 extended from the outer surface of the cooling channel 130 so as to enlarge the surface area to be in contact with the coolant.

As described above, the surface area in contact with the coolant is enlarged through the cooling fins 131 formed in the cooling channel 130, thereby increasing a cooling rate for the circuit board 110.

To secure a heat dissipation area of the cooling channel 130, the length of the cooling fin 131 may be at least 5 mm.

The cooling fin 131 may be extended to have an end portion to be spaced apart from the lower surface of the coolant flow channel 210.

The cooling fin 131 may be extended to be inserted in the coolant flow channel 210, and the end portion of the cooling fin 131 extended from the cooling channel 130 to the coolant flow channel 210 may be spaced apart from the lower portion of the coolant flow channel 210 at a preset distance.

Thus, a space is formed, and it is possible to adjust a flow rate of the coolant as the coolant flows in the space and between the cooling fins 131. Further, it is possible to affect on preventing the cooler 200 or the cooling fin 131 from being damaged when the cooler 200 and the circuit board 110 are coupled together.

The cooling channel 130 may include a plurality of cooling fins 131 disposed in a preset pattern.

As shown in FIG. 4, the plurality of cooling fins 131 extended downwards from the cooling channel 130 may be spaced apart from each other and disposed forming a preset pattern.

By adjusting the number of cooling fins 131 in this way, an insulator 150 may be further provided to surround the outer sides of the circuit board 110 and the semiconductor chip 120 and the lateral side of the cooling channel 130.

As shown in FIGS. 1 and 2, the insulator 150 may be molded to surround the outer sides of the circuit board 110 and the semiconductor chip 120. The insulator 150 may be made of epoxy resin. The insulator 150 may be formed to surround up to the lateral side of the cooling channel 130.

With this structure, the circuit board 110 and the semiconductor chip 120 may be protected from external materials, and insulated from the outside so that the power module 100 can operate normally.

The insulator 150 may be welded to the outer side of the cooler 200.

The insulator 150 surrounding the outer side of the circuit board 110 may be coupled to the cooler 200 by laser welding, thereby directly connecting the circuit board 110 and the cooler 200 without using separate parts.

In the foregoing embodiments, the insulator 150 is coupled to the outer side of the cooler 200 by welding. Alternatively, the insulator 150 may be coupled to the cooler 200 by various methods.

The cooling channel 130 may be extended from the insulator 150 toward the cooler 200 and inserted in the coolant flow channel 210 of the cooler 200.

As shown in FIGS. 1 and 4, the cooler 200 may be formed with an insertion portion into which the cooling fin 131 and the cooling channel 130 are inserted when the cooler 200 is coupled to the insulator 150. The cooling channel 130 has a thickness set to protrude outers from the insulator 150 and is inserted in the insertion portion.

Accordingly, the insertion portion is sealed with the cooling channel 130 when the insulator 150 and the cooler 200 are welded, thereby affecting on preventing the coolant from leaking out.

Further, the insulator 150 is coupled to the cooler 200 in the state that the cooling channel 130 and the cooling fin 131 are inserted in the coolant flow channel 210, and it is thus possible to cool the circuit board 110 directly.

In addition, a copper clip may be further provided to connect with the semiconductor chip 120 or the lead frame 140 as coupled to the first side of the circuit board 110.

In a conventional single-sided cooling power module 100, an aluminum (Al) wire is used to flow a large current. However, the aluminum wire has a problem with increasing resistance and inductance.

To solve this problem, as shown in FIG. 3, the copper clip is used instead of the aluminum wire to increase electrical conductivity and decrease electrical resistance, thereby affecting on improving electrical performance.

The semiconductor chip 120 or the lead frame 140 may be coupled to the circuit board 110 by soldering or sintering.

The semiconductor chip 120 or the lead frame 140 may be bonded through a soldering or sintering process to electrically connect with a metal circuit of the circuit board 11.

When the circuit board 110 made of heavy Cu (1 mm or more) is used, high thermal stress is generated at a high temperature. To secure the durability of the semiconductor for the power circuit against the high thermal stress, the soldering process using highly heat-resistant solder (SAC, SnCu) or the sintering process using Silver (Ag) may be employed.

In a power module 100 for a vehicle according to another embodiment of the disclosure, the circuit boards 110 may be symmetrically provided up and down forming a pair, the cooling channels 130 may be symmetrically provided up and down forming a pair, the semiconductor chip 120 may be connected to one board of the circuit boards 110 forming a pair, and a spacer 160 may be further provided to connect the semiconductor chip 120 and the other board.

As shown in FIG. 2, the power module 100 according to another embodiment of the disclosure may have a double-sided cooling structure of the cooling channel 130, in which the circuit boards 110 form a pair, and the spacer 160 is provided to connect an upper circuit board 110 and a lower circuit board 110 or the semiconductor chip 120, thereby connecting the pair of circuit boards 110 with each other.

Thus, as shown in FIG. 5, cooling efficiency is significantly increased during double-sided cooling.

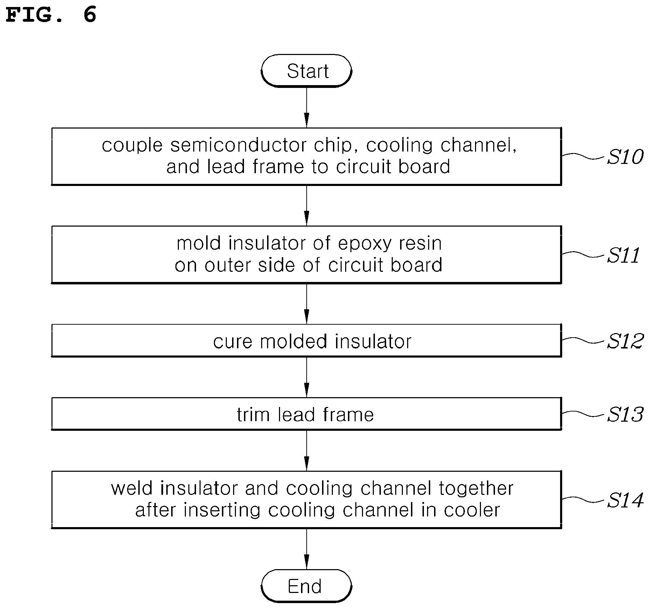

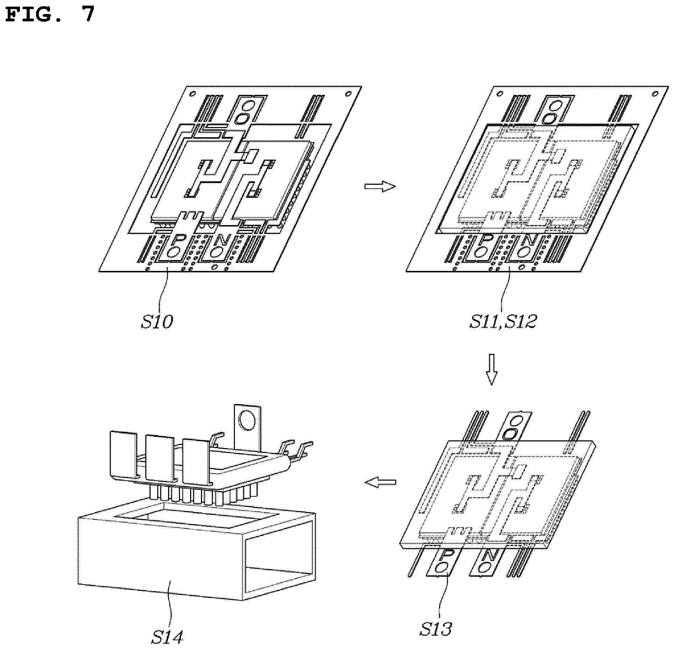

FIG. 6 is a flowchart showing a method of manufacturing a power module for a vehicle according to the disclosure, and FIG. 7 is a view illustrating the method of manufacturing a power module for a vehicle according to the disclosure.

Embodiments of a method of manufacturing the power module 100 for the vehicle according to the disclosure will be described with reference to FIGS. 6 and 7.

The method of manufacturing a power module 100 for a vehicle according to the disclosure includes steps of coupling a semiconductor chip 120, a cooling channel 130, and a lead frame 140 to a circuit board 110 (S10); molding an insulator 150 of an epoxy resin on the outer side of the circuit board 110 (S11); curing the molded insulator 150 (S12); and welding the insulator 150 and the cooling channel 130 together after inserting the cooling channel 130 in the cooler 200 (S14).

In coupling step S10, the semiconductor chip 120 and the lead frame 140 are bonded to the circuit board 110 provided with the metal circuit pattern 111 by soldering or sintering, and the cooling channel 130 is coupled to the circuit board 110. In molding step S11, the insulator 150 of epoxy resin is molded.

In curing step S12, the epoxy resin is cured to prevent the insulator 150 from separating. In welding step S14, the cured insulator 150 may be directly welded to the cooler 200.

After curing step S12, step S13 of trimming the lead frame 140 for signal connection with a gate board is added.

In the power module for the vehicle according to the disclosure, the circuit board includes the circuit pattern formed on the first side thereof, and the cooling channel provided on the second side thereof and coupled to the cooler, and the insulator insulating and surrounding the circuit board and the cooler are coupled together so that the cooling channel can directly dissipate heat from the circuit board, thereby having a significant effect on improving cooling efficiency.

Further, the circuit board is provided with the copper clip for connecting the semiconductor chip and the lead frame, thereby having an effect on improving electrical performance to increase electrical conductivity and decrease electrical resistance.

Although specific embodiments of the disclosure are illustrated and described, it will be obvious to a person having ordinary knowledge in the art that a variety of improvements and changes can be made in the disclosure without departing from the technical idea of the disclosure defined in the appended claims.

## Claims

1. A power module for a vehicle, comprising:
a first circuit board including a first circuit pattern;
a first semiconductor chip connected to a first side of the first circuit board;
a lead frame disposed on the first circuit board as being spaced apart from the first semiconductor chip, and electrically connected to the first semiconductor chip; and
a first cooling channel coupled to a second side of the first circuit board and inserted in and jointed to a first coolant flow channel of a first cooler.

2. The power module of claim 1, wherein the first cooling channel comprises a cooling fin extended toward the first coolant flow channel of the first cooler.

3. The power module of claim 2, wherein the cooling fin comprises an end portion to be spaced apart from a lower surface of the first coolant flow channel.

4. The power module of claim 1, wherein the first cooling channel comprises a plurality of cooling fins disposed in a preset pattern and extended toward the first coolant flow channel of the first cooler.

5. The power module of claim 1, further comprising an insulator surrounding outer sides of the first circuit board and the first semiconductor chip and a lateral side of the first cooling channel.

6. The power module of claim 5, wherein the first cooling channel is extended from the insulator toward the first cooler and inserted in the first coolant flow channel of the first cooler.

7. The power module of claim 5, wherein the insulator is welded to an outer side of the first cooler.

8. The power module of claim 1, further comprising a copper clip to connect with the first semiconductor chip or the lead frame as coupled to the first side of the first circuit board.

9. The power module of claim 1, wherein the first semiconductor chip or the lead frame is coupled to the first circuit board by soldering or sintering.

10. The power module of claim 1, further comprising a spacer, a second circuit board, a second semiconductor chip, and a second cooling channel,
wherein the first semiconductor chip, the first circuit board, and the first cooling channel are sequentially arranged on one side of the spacer in a direction away from the spacer, and
the second semiconductor chip, the second circuit board, and the second cooling channel are sequentially arranged on another side of the spacer opposing the one side in a direction away from the spacer.

11. The power module of claim 10, wherein the first and second circuit boards are symmetrically provided up and down forming a pair, the first and second cooling channels are symmetrically provided up and down forming a pair, and the first and second semiconductor chip are respectively connected to the first and second circuit boards forming a pair.

12. A method of manufacturing a power module for a vehicle, the method comprising:
coupling a semiconductor chip, a cooling channel, and a lead frame to a circuit board;
molding an insulator of an epoxy resin on an outer side of the circuit board;
curing the molded insulator; and
welding the insulator and the cooling channel together after inserting the cooling channel in a cooler.

13. The method of claim 12, further comprising trimming the lead frame for signal connection with a gate board after the curing.
